Europäisches Patentamt

European Patent Office

Office européen des brevets

(11) Publication number: **0 163 445**
**B1**

## (12) EUROPEAN PATENT SPECIFICATION

(45) Date of publication of patent specification: **30.01.91**

(51) Int. Cl.⁵: **H 01 L 21/203,** C 23 C 14/34, H 01 J 37/34

(21) Application number: **85303330.6**

(22) Date of filing: **10.05.85**

(54) Magnetron sputter device having planar and concave targets.

(30) Priority: **17.05.84 US 611433**

(43) Date of publication of application:
**04.12.85 Bulletin 85/49**

(45) Publication of the grant of the patent:
**30.01.91 Bulletin 91/05**

(84) Designated Contracting States:
**CH DE FR GB IT LI NL**

(56) References cited:
**WO-A-81/03345**
**FR-A-2 535 109**
**US-A-4 060 470**
**US-A-4 100 055**
**US-A-4 219 397**

**US-A-4 282 083**
**US-A-4 428 816**
**US-A-4 434 038**
**US-A-43 916 97**

**JOURNAL OF VACUUM SCIENCE AND TECHNOLOGY, vol. 14, no. 5, September/October 1977, New York, JAMES A. ARMINCK: "Deposition techniques for dielectric films on semiconductor devices", pages 1053-1063**

(73) Proprietor: **VARIAN ASSOCIATES, INC.**
**611 Hansen Way**
**Palo Alto, CA 94303 (US)**

(72) Inventor: **Helmer, John Colville**
**260 Balsamina Way**
**Menlo Park California (US)**

(74) Representative: **Cline, Roger Ledlie et al**
**EDWARD EVANS & CO. Chancery House 53-64**
**Chancery Lane**
**London WC2A 1SD (GB)**

Courier Press, Leamington Spa, England.

## Description

The present invention relates generally to magnetron sputter devices and more particularly to a magnetron sputter device having first and second targets.

Magnetron sputter devices are characterized by crossed electric and magnetic fields in an evacuated chamber into which an inert, ionizable gas, such as argon, is introduced. The gas is ionized by the electric field. The magnetic field confines the ionized gas, which forms a plasma, in proximity to a target structure which emits atoms that are incident on a workpiece; the workpiece is a substrate in a coating process or can be etched by the atoms. Generally, the magnetic field is established by a permanent magnet structure, although increasingly electromagnetic devices are being employed for this purpose. In coating applications, the magnetron sputtering devices are frequently employed to deposit metals in the manufacture of electronic, integrated circuit type devices. It is also known to deposit magnetic materials in the manufacture of high density magnetic discs of a type used for magnetic disc memories.

In prior art magnetron sputtering devices, uniform coating thickness across a substrate was obtained by moving the substrates during coating. Moving the substrates also assisted in obtaining optimum step coverage, i.e., step type transitions from one coating to another. Of course there are many problems in moving a substrate during operation of a sputtering device. It is also desirable in certain instances to co-deposit different materials, particularly materials which are different or impossible to alloy. These materials are not adapted to be located on a single target. In all instances, it is desirable to operate the sputter device at as high a rate as possible.

WO—A—81/03345 emanating from the same applicants describes a circular magnetron sputter source employing a central anode surrounding by an annular cathode of generally inverted conical configuration which acts as a target of material to be sputtered onto a workpiece.

Reference is made to co-pending applications 85303331.4 (EP—A—0 162 642), 85303332.2 (EP—A—0 163 446) and 85303333.0 (EP—A—0 162 643) which describe and claim similar subject matter.

US—A—4219397 discloses a target set with two co-axial target elements, both cathodes of sputtering material. Both are annular, one being axially displaced in relation to the second, but still in contact therewith. US—A—4391697 discloses a set of two plane targets, with one separated from the other by a ceramic spacer.

The present invention provides in one aspect a special assembly, as set out in Claim 1. With the present invention, there is a more uniform deposition of material over a larger area and improved step coverage over a larger area, such as six inches (15.2 cm) across, because of the special shape of the particle emitting surfaces.

The step coverage is particularly improved in the outer portion of the workpiece. The invention also includes a vacuum sputter device as set out in Claim 10.

An example of the present invention will now be described with reference to the accompanying drawings, in which:-

Figure 1 is a schematic diagram of a sputtering device incorporating a two target set,

Figure 2 is a cross-sectional view of a target assembly, including a magnetic circuit and cooling structure, taken along the lines 2—2 of Figure 3,

Figures 3 and 4 are respectively top and bottom views of the assembly illustrated in Figure 2, and

Figure 5 is a diametral cross-section through a modified two target set.

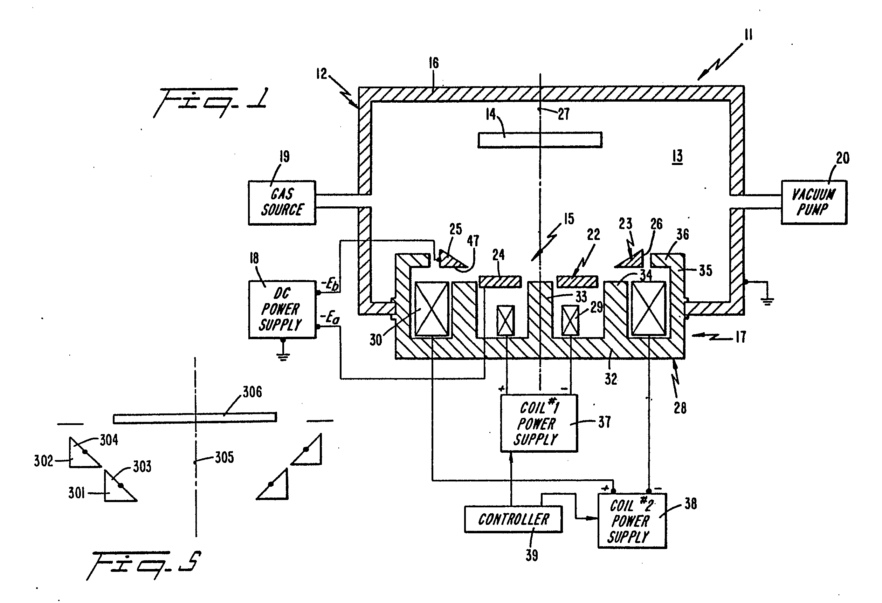

In Figure 1 magnetron sputtering apparatus 11 includes vacuum chamber 12, containing enclosed sputter coating processing or depositing volume 13 in which workpiece 14 is fixedly mounted by conventional means (not shown). While the detailed description assumes that workpiece 14 is a substrate to be coated, it is to be understood that the invention is also applicable to etching of material from the workpiece. Typically, substrate 14 is part of an integrated circuit having relatively larger diameter, such as four to six inches (10.1—15.1 cms), on which material is deposited forstep coverage. In such a situation non-magnetic material is deposited on the substrate.

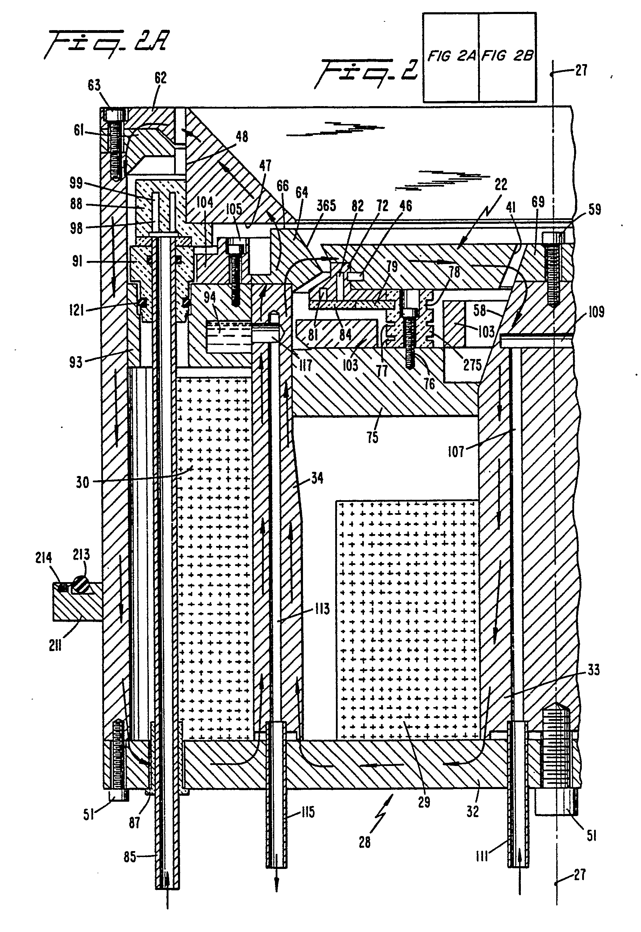

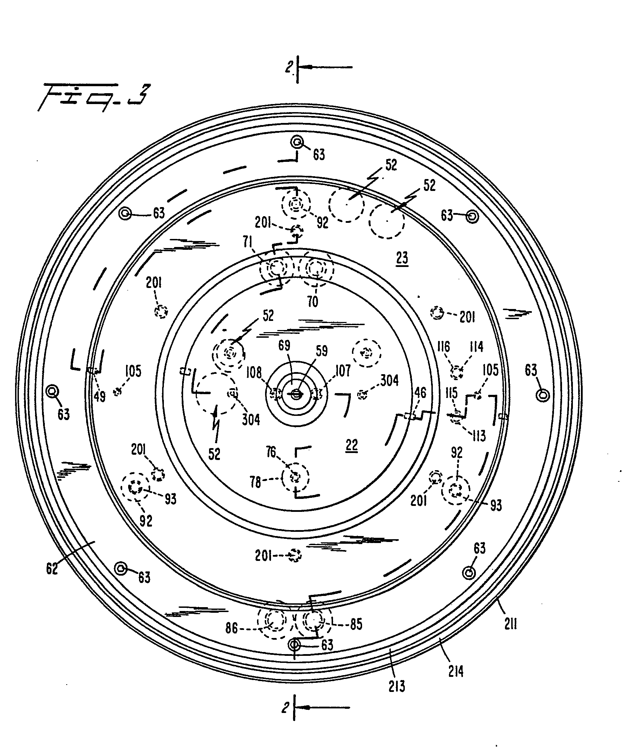

It is to be understood, however, that certain modifications of the specific structure described in connection with Figures 2—4 are generally necessary to provide optimum results for deposition of magnetic materials on substrate 14 to form devices such as magnetic disc memories. Each target for sputtering magnetic materials includes a relatively thin magnetic strip mounted on a non-magnetic, metallic holder. The magnetic portion is relatively thin, between one-quarter and one-half inch (0.6—1.3 cms), so magnetic field lines are not affected materially by them. The magnetic material is saturated to minimize the effect thereof on the magnetic flux flowing through it. Layers of different materials can be deposited on substrate 14 by the apparatus illustrated in Figure 1, by suitable choice of target materials for cathode assembly 15.

Chamber 11 includes a metallic electrically grounded, exterior housing 16, made of a material having high electric conductivity. Housing 16 is a part of an anode assembly and is generally formed as a cylinder having an axis concentric with substrate 14, in turn coaxial with target cathode assembly 15. Targets in cathode assembly 15 are maintained at negative high voltage potentials relative to ground by DC power supply 18.

To establish a plasma in processing volume 13 in the vicinity of cathode assembly 15, an inert gas, typically argon, is supplied to the processing volume from pressurized inert gas source 19. The processing volume is evacuated by vacuum pump 20. The combination of gas source 19 and vacuum pump 20 maintains processing volume 13 at a relatively low pressure, such as 7 millitorr.

Cathode assembly 15 includes two target elements 22 and 23, respectively having planar, annular atom emitting surface 24 and concave atom emitting surface 25, shaped as a side wall of frustum of a cone having a base 26 at right angles to the longitudinal axis of disc shaped target element 22. Surface 24 is inclined throughout its length at an angle of 45° relative to base 26. Target elements 22 and 23 are concentric to each other, having coincident axes along axis 27 of substrate 14. The particular configurations of target elements 22 and 23 are described in detail infra, in connection with Figures 2—4.

Separate plasma discharges are established and confined over target elements 22 and 23. The separate discharges are confined by separate, variable magnetic fields coupled to target elements 22 and 23 by magnetic (preferably iron) pole piece assembly 28 in response to magnetic fields derived from toroidal electromagnets 29 and 30. Pole piece assembly 28 and coils 29 and 30 are axially symmetric with and concentric to axis 27, with coil 30 being located outside of coil 29.

Pole piece assembly 28 includes disc shaped base 32, disposed at right angles with respect to axis 27, in combination with central stud 33, and rings 34 and 35. Stud 33 extends along axis 27, while rings 34 and 35 are concentric with axis 27, with the stud and each ring extending longitudinally from base 32 towards substrate 14. Stud 33 is centrally located, in a cylindrical space within coil 29, while ring 34 extends between coils 29 and 30. Ring 35 is outside of coil 30 and target element 23. Ring 35 includes inwardly directed flange 36, at right angles to axis 27. Ring 34 is proximate the outer diameter of annular target element 22 and a lower face of target element 23, while central stud 33 is proximate the inner diameter of target element 22.

Separate, independently controlled currents are supplied to electromagnet coils 29 and 30 by DC power supplies 37 and 38, respectively. Power supplies 37 and 38 are separately controlled in response to signals derived from controller 39 so that as target elements 22 and 23 erode during use, the currents supplied to coils 29 and 30 change to maintain the discharge impedances relatively constant.

To establish the separate discharges, DC power supply 18 maintains target elements 22 and 23 at different negative DC high voltage levels -$E_a$ and -$E_b$, respectively. The detailed structures of pole piece assembly 28 and for supplying DC power to target elements 22 and 23 are described infra in connection with Figures 2—4.

In general, the DC currents supplied to coils 29 and 30 and the construction of pole piece assembly 28 establish magnetic flux lines in target elements 22 and 23 which intersect emitting surface 24 and pass in a first generally vertical direction, e.g. upwardly, through the boundary of annular emitting surface 24 in proximity to the outer diameter of the emitting surface. The same flux lines pass in a second generally vertical direction, e.g. downwardly, through emitting surface 24 in proximity to the inner radius of the emitting surface. Similarly, the flux lines which pass through emitting surface 25 toward axis 27 in proximity to the outer radius of the emitting surface also pass back into target element 23 at the inner radius of the target element. Thereby, separate plasma discharges are contained above the emitting surfaces 24 and 25 and the erosion profiles of target elements 22 and 23 are centered on the emitting surfaces fo the targets. The angle between the magnetic field lines traversing the boundaries defined by surfaces 24 and 25 is maintained very low by the magnetic pole assembly 28 so that the magnetic field is very uniform over emitting surfaces 24 and 25. It is important to maintain the plasma density as uniform as possible immediately over emitting surfaces 24 and 25 to provide uniform erosion from the emitting surfaces, and thereby minimize the tendency for a "V" erosion profile which induces target self-shadowing by emitted material. Self-shadowing is a phenomenon whereby material emitted or sputtered from the target collects on the target and has a tendency to prevent escape of further material from the target toward the substrate.

The magnetic field coupled by coil 29 to pole piece assembly 28 causes magnetic flux to flow through a first magnetic circuit. The flux in the first magnetic circuit flows axially along stud 33, thence axially and radially through target element 22 and slightly above emitting surface 24 thereof. From target element 22 and the space immediately above emitting surface 24, the magnetic flux flows axially, and radially to ring 34, thence axially along ring 34 to base 32. In base 32, the first magnetic circuit is completed by the flux flowing radially back to stud 33.

The magnetic flux established by electromagnet 30 flows through a second magnetic circuit. The flux in the second magnetic circuit flows axially through ring 35, thence radially through flange 36 into target element 23. The magnetic flux flows in target element 23 and slightly above emitting surface 25 thereof, thence into ring 34. In ring 34, the magnetic flux flows axially back to base 32, where in flows radially outwardly to ring 35 to complete the second magnetic circuit. The directions of windings of electromagnets 29 and 30 and the polarities of the currents applied to the electromagnets by power supplies 37 and 38 are such that the first and second magnetic circuit fluxes in ring 34 flow in opposite directions, to (1) avoid saturation of the magnetic material forming ring 34, (2) reduce the size and weight of cathode assembly 15, and (3) improve efficiency.

If target elements 22 and 23 are magnetic, sufficient current is supplied by power supplies 37 and 38 to electromagnets 29 and 30 to saturate the magnetic targets so that fringing fields subsist above the targets to confine the plasma immediately above emitting surfaces 22 and 23.

3

Targets 22 and 23 are located relative to each other and spaced from substrate 14 to enable material to be coated uniformly across the surface of the substrate. The relative sputter rates from surfaces 24 and 25 are adjusted during the lift of device 11 by controlling power supplies 37 and 38 to maintain uniform deposition on different ones of substrates 14 as emitting surfaces 24 and 25 of targets 22 and 23 erode.

Target elements 22 and 23, as well as pole piece assembly 28, are cooled, in a manner described infra in detail, in connection with Figures 2—4. The same structure which cools target elements 22 and 23 supplies DC operating voltages from supply 18 to them. The structures which supply cooling fluid to pole piece assembly 28 also assist in supporting the pole piece assembly.

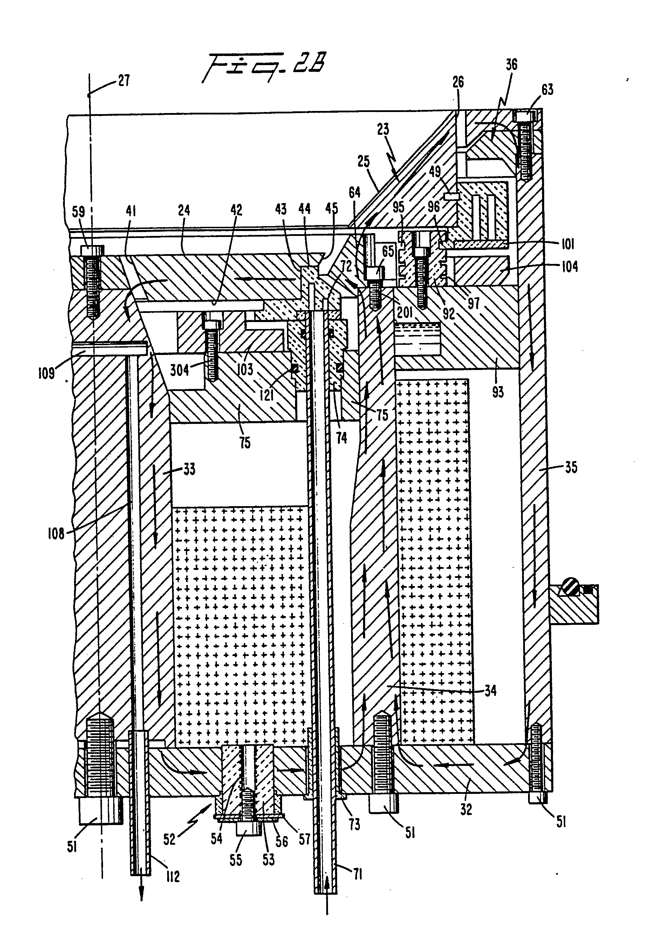

Reference is now made to Figures 2—4 of the drawings, wherein there are illustrated detailed views of cathode assembly 15. It is noted from a comparison of Figures 2 and 3 that the cross-sectional view of Figure 2 is along a rather circuitous path indicated by the dotted line 2—2, Figure 3; such a cross-sectional view enables the most important features of cathode assembly 15 to be most clearly illustrated.

Disc like target element 22, in addition to including planar, annular emitting surface 24, includes tapered interior radius 41 that flares outwardly from axis 27 as it extends in a generally longitudinal direction of target 22 toward planar face 42, opposite from and parallel to emitting face 24. The outer perimeter of target 22 includes an axially extending segment 43 which intersects face 42, as well as radially extending rim 44, which is disposed parallel to surfaces 24 and 42. Extending generally axially between surface 24 and rim 44 is beveled surface 45. On axially extending wall segment 43 are two diametrically opposed cut-out segments 46, each shaped as a parallelepiped to receive a non-magnetic pin which assists in holding target element 22 in situ; preferably the pins in cut-out segments 46 are formed of a berylium-copper alloy.

Target element 23 is formed as a ring having concave emitting surface 25, in combination with base 47 and cylindrical side wall 48. Base 47 and side wall 48 are respectively at right angles to and parallel with axis 27. Concave emitting surface 25 is formed as a wall of a frustum of a cone that is inclined 45° with respect to base 47 and wall 48 throughout the length of the surface. A short second base 26 is disposed between the top edge of face 25 most remote from axis 27 and side wall 48. Diametrically opposed cut-outs 49 in side wall 48 receive non-magnetic berylium-copper alloy pins to hold target element 23 in situ.

Target elements 22 and 23 are arranged so that the outer radius of planar annular emitting surface 24, having a radius $R_2$, is less than the inner radius $R_3$, of inclined emitting surface 25. Of course, the outer radius $R_4$ of emitting surface 25 is greater than radius $R_3$, and the inner radius, $R_1$, of surface 24 is less than radius $R_2$.

As illustrated in Figures 2, pole piece assembly 28 includes several individual structures whereby central pole piece stud 33, intermediate pole piece ring 34 and outer pole piece ring 35 are mounted on and secured to base 32 by screws 51. Coils 29 and 30 are mounted on base 32, with current being supplied to the coils from supplies 37 and 38 by identical contact assemblies 52.

As illustrated in Figure 2, one of assemblies 52 includes electric insulating sleeve 53 having a relatively thick metallic coating 54 on the interior wall thereof into which is threaded metal screw 55 that bears against metal flat washer 56. A terminal lug (not shown) is connected to a lead between the head of screw 55 and washer 56 to a terminal of power supply 37. To electrically insulate the lug from the remainder of the sputtering device, dielectric washer 57 is interposed between washer 56 and the top face of sleeve 53.

To assist in providing the desired magnetic field shape, central pole piece stud 33 is cylindrically shaped, having an upward, inwardly inclined segment that is capped by non-magnetic, metal (preferably aluminum) cap 58. The upper portion of stud 33 is inclined with respect to axis 27 by the same angle as the inclination angle of inner surface 41 of target 22. Because surface 41 and the upper portion of stud 33 are inclined at the same angle, there is a constant spacing between them to assist in establishing a uniform magnetic field across and above the emitting surface 24. Cap 58 is held in situ on stud 33 by non-magnetic, preferably aluminum, screw 59.

Ring 34 includes upper and lower segments, having walls parallel to axis 27, and a central segment with an interior wall that is inclined outwardly with respect to axis 27. Thereby, the inner wall of ring 34 has a diameter slightly greater than that of the lower segment of the ring, to assist in concentrating the magnetic field supplied by coil 30 to the ring.

Ring 35 has walls of constant thickness throughout substantially the entire length thereof. At the upper end of ring 35 is inwardly extending flange 36, formed of two separate abutting magnetic elements, namely exterior pole piece insert 61 and outer pole piece shield 62, held in situ by metal non-magnetic, preferably aluminum, screw 63. The interior faces of insert 61 and shield 62 are spaced from outer wall 48 of target 23, whereby an air gap having a constant separation between the target and pole pieces is established.

To couple magnetic flux from intermediate ring 34 to both of targets 22 and 23, middle pole piece insert 64 is mounted by metal non-magnetic, preferably aluminum, screws 65 on the top face of the intermediate ring. Pole piece 64 is configured to provide a constant air gap between it and the opposing faces 45 and 47 of targets 22 and 23. To this end, pole piece insert 64 includes an outwardly tapered inner cylindrical like wall 65 which extends from a plane below the plane of target face 44 to the top of the pole piece insert. The top of pole piece 64 is defined by planar annulus 66, disposed parallel to bottom face 47 of target 23. Face 66 extends radially outward from axis 27 from a point just outside of the intersection of emitting surface 25 and planar surface 47 of target 23 to a point approximately one-quarter of the length of face 47 in the radial direction. The geometry provides a constant air gap between pole piece insert 64 and each of targets 22 and 23.

Target cathodes 22 and 23 are maintained at different high voltage negative potentials relative to grounded pole piece assembly 28, with target 22 being maintained at a voltage of $-E_a$ and target 23 being maintained at a potential of $-E_b$. Because of the air gap subsisting between targets 22 and 23 and the adjacent pole piece elements, namely aluminum cap 69 on central pole piece 33, central pole piece insert 64, and outer pole piece insert 61 and shield 62 therefor, electric lines of force subsist along the air gaps and through the targets.

Target 22 is supplied with a voltage of $-E_a$ by axially extending metal, non-magnetic (preferably copper) tube 71 which is mechanically and elelctrically connected to metal, non-magnetic (preferably copper) ring 72, having an axis coincident with axis 27. Ring 72 also supports the underneath side of target 22 by abutting against intersecting horizontally and vertically extending faces 42, 43 and 44 of the target. Small cut-outs are provided in ring 72 to receive the same non-magnetic pins which engage cut-outs 46 to hold target 22 in situ. Ring 72 and face 42 abut against each other through a distance of approximately one-quarter of the radius of face 42, between the outer edge of target 22, toward the center thereof.

Tube 71 passes through base 32, but is electrically insulated from it by virtue of axially extending dielectric sleeve 73. The end of tube 71 proximae ring 72 is supported by sleeve like, dielectric spacer 74, in turn supported by metal, non-magnetic, preferably stainless steel, bulk head 75 which extends radially between and is connected to central pole piece 33 and intermediate pole piece 34. A lug (not shown) fits over copper tube 71 and is connected to a lead, in turn connected to voltage terminal $E_a$ of DC power supply 18.

A portion of target 22 on the opposite side of axis 27 is supported by dielectric stud 275, having an axial threaded bore into which non-magmetic, metal screw 76 is threaded; screw 76 extends into a similar threaded bore in bulk head 75 to hold stud 275 in situ. Stud 275 is provided with radially extending, axially spaced slots 77 which assist in preventing electric breakdown between the stud and adjacent metallic parts. Slots 77 have a high flow impedance to metal particles from targets 22 and 23, to prevent migration of the metal into the slots and thus preserve the electric insulating properties of the stud. Stud 275 includes a further radially extending slot 78 in which is captured horizontally extending support shoulder 79 for the bottom face of ring 72. From the foregoing, target 22 is supported mechanically and electrically maintained at a potential of $-E_a$ and is electrically isolated from ground and target 23 by the same structure.

The support structure for target 22 also enables the target to be cooled. To this end, ring 72 is provided with a pair of annular, axially extending slots 81 and 82, in fluid communication with the interior of tube 71. A cooling fluid, preferably water, supplied to the interior of tube 71 flows into slots 81 and 82 to cool the entire circumference of ring 72. Slots 81 and 82 extend around virtually the entire extent of ring 72. Water in slots 81 and 82 flows out of the slots through copper tube 83, Figure 3, adjacent tube 81. Annular gasket 84, mounted on the bottom face of copper ring 72, covers slots 81 and 82, except where the slots are connected to tubes 71 and 83, to provide a fluid tight seal between the slots and the remainder of the device. Tube 83 extends through base 32 in the same manner as tube 71 and is electrically isolated from the base by a sleeve identical to sleeve 73.

Target 23, electrically connected to supply source voltage $-E_b$, is mechanically supported and cooled in a manner similar to the described for target 22. In particular, target 23 is electrically connected to axially extending copper tubes 85 and 86, which extend through base 32 and are electrically insulated from the base by dielectric sleeves 86. Current from copper tube 85 flows into ring 88, which abuts against and holds intersecting cylindrical wall 48 and planar face 47 of target 23. Ring 88 includes small cut-out segments for receiving the same non-magnetic pins which engage cutouts 49, to hold target 23 in situ. Ring 88 is mechanically supported and electrically insulated from the remainder of the device by axially extending dielectric sleeves 91 and 92.

Sleeve 91 has a central bore through which copper tube 85 extends. Sleeve 91 includes shoulders which abut downwardly against metal, non-magnetic, preferably stainless steel, bulk head 93 that extends radially between and is machanically connected to intermediate pole piece 34 and outer pole piece 35.

Along the interior wall of bulk head 93 is an annular channel 94 through which cooling fluid is circulated, as described infra. Ring support sleeve 92 includes a radial slot 95 which receives and carries inwardly extending flange 96 of copper ring 88. Sleeve 92 also includes radially extending slots 97 which perform the same function as similar slots 77 on support sleeve or stud 75.

To cool targets 23, ring 88 is provided with a pair of annular, axially extending slots 98 and 99, in fluid communication with the interior of tubes 85 and 86. Slots 98 and 99 extend virtually around the entire extent of ring 88 in the same manner as described for slots 81 and 82 in ring 72. A fluid seal is provided for slots 98 and 99 by annular gasket 101, which abuts against and extends radially along the lower face of ring 88 except in the region where slots 98 and 99 are connected to the interior of tubes 85 and 86.

To assist in maintaining a relatively constant electric field gap between high voltage targets 22 and 23 and the surrounding, electrically grounded parts of cathode assembly 15, metal, non-magnetic, preferably aluminum, annular spacers 103 and 104 are provided. Inner spacer 103 is mounted on and secured to bulk head 75 by metal, non-magnetic screws 304. Spacer 103 extends radially from a region slightly outside of central pole piece 33 to a region slightly inside of intermediate pole piece 34. Spacer 104 is mounted on and secured to bulk head 93 by screws 105. Spacer 104 extends radially from a position aligned with the outer wall of the intermediate pole piece 34 to a position just inside of the interior wall of pole piece 35. A constant gap subsists between spacers 103 and 104 and the adjoining metal parts to minimize high voltage discharges and thereby prolong the life of the unit.

To maximize efficiency, pole piece assembly 28 and the target assembly including target elements 22 and 23, is cooled. To cool the pole piece assembly 28, central pole piece 33 includes axially and radially extending bores 107, 108 and 109. Radially extending bore 109 is in proximity to the top of pole piece 33, proximate target 22. Bores 107 and 108 are connected to a water supply and water sump by way of tubes 111 and 112 which extend through base 32. To cool pole piece 34, it includes axially extending bores 113 and 114, respectively connected to tubes 115 and 116 which extend through base 32 to a water supply and sump. At the end of bore 113 adjacent bulk head 97 is outwardly extending passage 117 through which cooling fluid flows between bore 113 and annular fluide passage 94. Thereby, cooling fluid flows circumferentially about the perimeter of pole piece 34, to cool the pole piece. it has been found that it is not necessary to cool outer pole piece 35 because of the large exposed area thereof and because of its remoteness from the center of cathode assembly 15.

In operation, targets 22 and 23 expand with heating from the discharge power dissipated as material is sputtered from them. Expansion of targets 22 and 23 results in more intimate contact between the targets and support rings 72 and 88. Thereby, tight seals are respectively made between targets 22 and 23 and rings 72 and 98, to provide better heat transfer between the targets and rings and thereby increase cooling efficiency in transferring heat from the targets to the rings.

Vacuum integrity is maintained in the space above targets 23 and 24, as well as in the region where the plasma discharge is confined between cathode assembly 15 and substrate 14 with bulk heads 75 and 93. All elements which fit through the bulk heads are sealed to walls within the bulk heads by O-rings 121; for example, insulating sleeves 74 and 91 are respectively sealed to bulk heads 75 and 93 by O-rings 121.

Cathode assembly 15 is secured to chamber 16 by axially displaced, radially extending mounting flanges 211 and 212, fixedly mounted on the exterior side wall of pole piece 35. To provide the proper seal, flange 211 includes a slot for carrying O-ring 213. Rf shield 214 is located in a further slot in flange 211. Flange 212 includes a groove for receiving an O-ring which abuts against chamber 16.

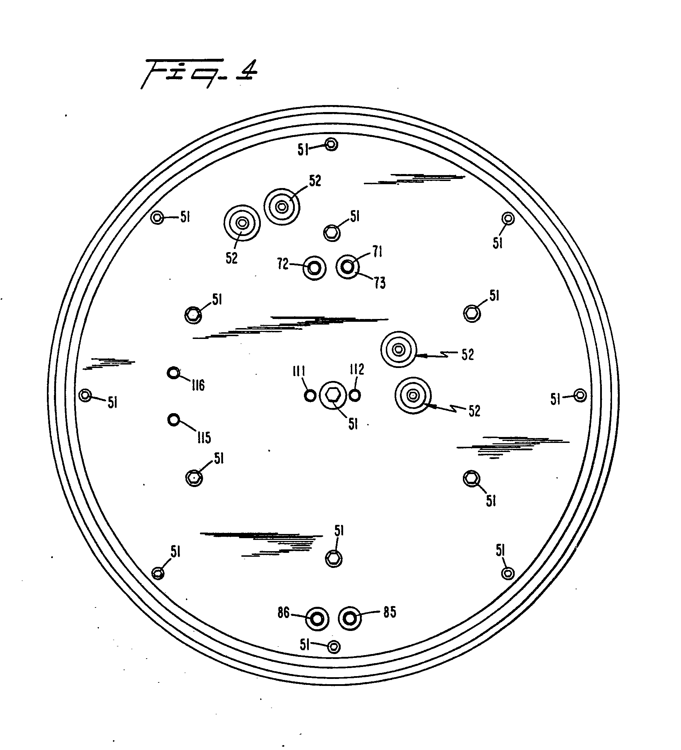

Figure 5 is a schematic diagram of a modified target configuration.

The assembly of Figure 5 includes separate inner target 301 and outer target 302, each having a separate discharge provided by a structure similar to that illustrated in Figures 1—4. Targets 301 and 302 respectively have aligned coaxial, inclined, concave emitting surfaces 303 and 304, defined by frusta of a common cone. In the illustrated embodiment, surfaces 303 and 304 are both inclined at an angle of 45° relative to common vertically extending longitudinal axis 305 thereof. Emitting surfaces 303 and 304 have the same length. The configuration of Figure 5 provides results similar to those of the embodiment of Figures 1—4 except that the outer step coverage of the embodiment is lower than in the embodiment of Figures 1—4.

The inclination angle of the arrangement illustrated in Figure 5 can vary. In one particularly advantageous configuration the inclination angle is $\tan^{-1} 0.5$, i.e., 26.6°. In the modification wherein the inclination is 26.6° the emitting surfaces have the same length, with the mid point of the inner target emitting surface being spaced from the common target axis by one-half of the distance between the axis and the mid point of the outer target emitting surface. This modified target structure provides improved efficiency but lower out step coverage than the target structure of Figures 1—4.

While there has been described and illustrated one specific embodiment of the invention, it will be clear that variations in the details of the embodiment specifically illustrated and described may be made without departing from the invention as defined in the appended claims. For example, the DC plasma excitation fields can be replaced by RF fields.

## Claims

1. A target set for a vacuum sputtering device comprising first and second cathode elements of sputtering material, the second (23) surrounding the first (22), the geometries of the first and second elements being such that when they are in vacuum, material can be sputtered from the emitting surface (25) of the second elements which surface lies outside that (24) of the first element, characterized in that the first target element is an annular cathode and the initial emitting surface (25) of the second element is frusto conical.

2. A set as claimed in Claim 1, wherein the first and second elements are mutally spaced.

3. A set as claimed in Claim 2 wherein the first and second elements are mutually electrically insulated.

4. A set as claimed in any one of Claims 1 to 3 wherein the initial emitting surface (24) of the first element is frusto conical.

5. A set as claimed in claim 4 wherein the initial emitting surfaces (24, 25) of both elements lie on the surface of the same cone.

6. A set as claimed in any one of claims 1—5 wherein the half-angle of the cone is 45°.

7. A set as claimed in any one of claims 1 to 6 wherein the perimeter of the first target element (22) is circular with a radius R2, and the initial emitting surface (25) of the second target element has inner and outer radii of R3 and R4 respectively, where R2 is less than R3 which is less than R4.

8. A target set as claimed in any one of Claims 1 to 7 wherein a said target has at least one hole (46, 49) adapted to receive a pin to assist in holding said target in situ.

9. A target set as claimed in Claim 8 wherein said hole is located in an axially extending wall of the outer periphery of the target.

10. A vacuum sputter device for causing material to be sputtered onto a workpiece, the device comprising a target set (15) as claimed in any one of claims 1 to 9, means (19) for supplying an ionizable gas to a space adapted to be evacuated, the space being between the target assembly and workpiece (14), means (18) for establishing an ionizing electric field for the gas in the space, and means (37—39) for establishing a confining magnetic field for the gas ionized by the electric field in the vicinity of the emitting surfaces of the first and second targets (22, 23).

**Patentansprüche**

1. Targesatz für eine Vorrichtung zum Sputtern im Vakuum mit einem ersten und zweiten Kathodenelement aus Sputtermaterial, wobei das zweite (23) das erste (22) umgibt, die Geometrien des ersten und zweiten Elementes so sind, dass, wenn sie sich im Vakuum befinden, Material von der emitierenden Oberfläche (25) des zweiten Elementes, welche Oberfläche ausserhalb derjenigen (24) des ersten Elementes liegt, gesputtert werden kann, dadurch gekennzeichnet dass das erste Targetelement eine ringförmige Kathode ist und die anfängliche emitierende Oberfläche (25) des zweiten Elementes kegelstumpfförmig ist.

2. Satz nach Patentanspruch 1, dadurch gekennzeichnet, dass das erste und zweite Element gegenseitig mit Zwischenraum angeordnet sind.

3. Satz nach Patentanspruch 2, dadurch gekennzeichnet, dass das erste und zweite Element gegenseitig elektrisch isoliert sind.

4. Satz nach einem der Patentansprüche 1 bis 3, dadurch gekennzeichnet, dass die anfänglich emitierende Oberfläche (24) des ersten Elementes kegelstumpfförmig ist.

5. Satz nach Patentanspruch 4, dadurch gekennzeichnet, dass die anfänglich emitierenden Oberflächen (24, 25) beider Elemente auf der Oberfläche desselben Kegels liegen.

6. Satz nach einem der Patentansprüche 1 bis 5, dadurch gekennzeichnet, dass der halbe Winkel des Kegels 45° beträgt.

7. Satz nach einem der Patentansprüche 1 bis 6, dadurch gekennzeichnet, dass die · äussere Begrenzung des ersten Targetelementes (22) kreisförmig ist mit einem Radius R2 und die anfängliche emitierende Oberfläche (25) des zweiten Targetelementes einen inneren und äusseren Radius R3 respektive R4 aufweist, wobei R2 kleiner als R3 und R3 kleiner als R4 ist.

8. Targetsatz nach einem der Patentansprüche 1 bis 7, dadurch gekennzeichnet, dass ein genanntes Target mindestens ein Loch (46, 49) aufweist, welches passend ist um einen Stift aufzunehmen, um die Halterung des genannten Targets an Ort und Stelle zu unterstützen.

9. Targetsatz nach Patentanspruch 8, dadurch gekennzeichnet, dass das genannte Loch in einer sich axial erstreckenden Wand der äusseren Peripherie des Targets angeordnet ist.

10. Vorrichtung zum Sputtern im Vakuum zum Sputtern von Material auf eine Werkstück mit einem Targetsatz (15) nach einem der Patentansprüche 1 bis 9, Mitteln (19) zur Zuführung eines ionisierbaren Gases zu einem zum Evakuieren eingerichteten Raum, wobei der Raum zwischen der Targetanordnung und dem Werkstück (14) angeordnet ist, Miteln (18) zum Errichten eines ionisierenden elektrischen Feldes für das Gas im Raum und Mitteln (37—39) zum Errichten eines begrenzenden magnetischen Feldes für das durch das elektrische Feld ionisierte Gas in der Nähe der emitierenden Oberflächen der ersten und zweiten Targets (22, 23).

**Revendications**

1. Lot de cibles pour un dispositif de vaporisation sous vide comprenant un premier et un second élément de cathode de matériau de vaporisation, le second (23) entourant le premier (22), les géométries du premier et du second élément étant telles que lorsqu'ils sont sous vide, du matériau peut être vaporisé de la surface d'émission (25) du second élément dont la surface est située à l'extérieur de celle (24) du premier élément, caractérisé en ce que le premier élément de cible est une cathode annulaire et la surface d'émission initiale (25) de second élément est en tronc de cône.

2. Lot selon la revendication 1, dans lequel le premier et le second élément sont espacés l'un de l'autre.

3. Lot selon la revendication 2, dans lequel le premier et le second élément sont électriquement isolés l'un de l'autre.

4. Lot selon l'une des revendications 1 à 3, dans lequel la surface d'émission initiale (24) du prémier élément est en tronc de cône.

5. Lot selon la revendication 4, dans lequel les surfaces d'emission initiales (24, 25) des deux éléments sont disposées à la surface du même cône.

6. Lot selon l'une des revendications 1 à 5, dans lequel le demi-angle du cône est de 45°.

7. Lot selon l'une des revendications 1 à 6, dans lequel le périmètre du premier élément de cible (22) est circulaire avec un rayon $R_2$, et la surface d'émission initiale (25) du second élément de cible a un rayon interne et un rayon externe respectivement $R_3$ et $R_4$, avec $R_2$ étant plus petit que $R_3$, qui est plus petit que $R_4$.

8. Lot de cibles selon l'une des revendications 1 à 7, dans lequel une dite cible a au moins un trou (46, 49) adapté pour recevoir une pointe pour permettre de maintenir en place ladite cible.

9. Lot de cibles selon la revendication 8, dans lequel ledit trou est disposé dans une paroi s'étendant axialement de la périphérie extérieure de la cible.

10. Dispositif de vaporisation sous vide pour que du matériau soit vaporisé sur une pièce, le dispositif comprenant un lot de cibles (15) selon l'une des revendications 1 à 9, des moyens (19) pour fournir un gaz ionisable dans un espace adapté pour être mis sous vide, l'espace étant entre le dispositif de cibles et la pièce (14), des moyens (18) pour établir un champ électrique d'ionisation du gaz dans l'espace et des moyens (37, 39) pour établir un champ magnétique de confinement du gaz ionisé par le champ électrique, à proximité des surfaces d'émission des première et seconde cibles (22, 23).

*Fig.1*

*Fig.5*

EP 0 163 445 B1

*FIG. 2A*

*FIG. 2*

FIG 2A | FIG 2B

FIG. 2B

Fig. 3

FIG. 4